# EUROPEAN PATENT SPECIFICATION

(11) **EP 4 506 915 B1**
(45) Date of publication and mention of the grant of the patent: **20.05.2026**
(21) Application number: 24188144.0
(22) Date of filing: 11.07.2024
(51) Int. Cl.: G08B 3/10

(54) **DOORBELL DEVICE WITH CURRENT DETERMINATION AND CONFIGURATION FEATURE**
TÜRKLINGELVORRICHTUNG MIT STROMBESTIMMUNGS- UND KONFIGURATIONSFUNKTION
DISPOSITIF DE SONNETTE DE PORTE AVEC CARACTÉRISTIQUE DE DÉTERMINATION ET DE CONFIGURATION DE COURANT

(30) Priority: 11.08.2023 US 202318448322
(43) Date of publication of application: 12.02.2025
(60) Divisional application: 26169967.2
(73) Proprietor: Roku, Inc., San Jose, CA 95110 (US)
(72) Inventor: Garner, Greg, Key Colony Beach (US); Curtis, Robert Caston, Napa (US)
(74) Representative: Taor, Simon Edward William

(56) References cited:
- US-A1- 2020 005 604
- US-A1- 2020 005 625
- US-A1- 2020 388 118
- US-A1- 2022 237 993
- US-B2- 9 761 092

## Description

### USAGE AND TERMINOLOGY

In this disclosure, unless otherwise specified and/or unless the particular context clearly dictates otherwise, the terms "a" or "an" mean at least one, and the term "the" means the at least one.

### SUMMARY

In one aspect, and example doorbell device is disclosed. The doorbell device includes (i): a doorbell button; (ii) an energy storage device configured to provide energy to drive the doorbell device; (iii) electrical connectors configured to electrically connect the doorbell device in a doorbell circuit with a doorbell chime and a transformer, where the transformer provides current to the doorbell circuit; and (iv) a controller including at least one processor and non-transitory data storage, where the non-transitory data storage stores program instructions executable by the processor to cause the doorbell device to carry out operations. Prior art examples of similar or related systems are provided in US2020/388118, US2020/005625, US2020/005604, US2022/237993 and US9761092.

The operations carried out by the example doorbell device can include (i) drawing a current through the doorbell circuit; (ii) while drawing the current through the doorbell circuit, determining a maximum doorbell circuit current that will not activate the doorbell chime; and (iii) based on determining the maximum doorbell circuit that will not activate the doorbell chime, configuring the doorbell device to draw the determined maximum doorbell circuit current through the doorbell circuit. In an example embodiment, determining the maximum doorbell circuit current that will not activate the doorbell chime includes: (i) determining whether the current being drawn through the doorbell circuit has activated the doorbell chime, (ii) in response to determining that the current being drawn through the doorbell circuit has activated the doorbell chime, decrementing the current drawn through the doorbell circuit, and (iii) in response to determining that the current being drawn through the doorbell circuit has not activated the doorbell chime, incrementing the current drawn through the doorbell circuit.

In another aspect, an example method of configuring a doorbell device is disclosed. The method includes (i) drawing a current through a doorbell circuit; (ii) while drawing the current through the doorbell circuit, determining, by the doorbell device, a maximum doorbell circuit current that will not activate a doorbell chime; and (iii) based on determining the maximum doorbell circuit that will not activate the doorbell chime, configuring a doorbell device to draw the determined maximum doorbell circuit current through the doorbell circuit. In the example method, determining the maximum doorbell circuit current that will not activate the doorbell chime includes: (i) determining whether the current being drawn through the doorbell circuit has activated the doorbell chime, (ii) if the current being drawn through the doorbell circuit has activated the doorbell chime, decrementing the current drawn through the doorbell circuit, and (iii) if the current being drawn through the doorbell circuit has not activated the doorbell chime, incrementing the current drawn through the doorbell circuit.

In another aspect, an example non-transitory computer-readable medium is disclosed. The non-transitory computer readable medium has computer-executable instructions stored thereon that are executable by at least one processor to cause a computing system to perform operations, including: (i) drawing a current through a doorbell circuit; (ii) while drawing the current through the doorbell circuit, determining a maximum doorbell circuit current that will not activate a doorbell chime; and (iii) based on determining the maximum doorbell circuit that will not activate the doorbell chime, configuring the doorbell device to draw the determined maximum doorbell circuit current through the doorbell circuit. Determining the maximum doorbell circuit current that will not activate the doorbell chime includes: (i) determining whether the current being drawn through the doorbell circuit has activated the doorbell chime, (ii) in response to determining that the current being drawn through the doorbell circuit has activated the doorbell chime, decrementing the current drawn through the doorbell circuit, and (iii) in response to determining that the current being drawn through the doorbell circuit has not activated the doorbell chime, incrementing the current drawn through the doorbell circuit.

### BRIEF DESCRIPTION OF THE DRAWINGS

Figure 1 is a simplified block diagram of an example doorbell circuit in which various described principles can be implemented.
Figure 2 is a simplified block diagram of an example doorbell device.
Figure 3 is a simplified block diagram of an example doorbell chime.
Figure 4 is a simplified block diagram of an example computing system in which various described principles can be implemented.
Figure 5 is a flow chart of an example method.
Figure 6 is a flow chart of another example method.
Figure 7 is a flow chart of another example method.

### DETAILED DESCRIPTION

### I. Overview

Doorbell chime systems can be installed in homes to alert the user (e.g., the homeowner) that someone is at the door. Traditional doorbell chime systems are relatively simple electrical doorbell circuits. First, there is a doorbell button module including a push button located outside the home. The doorbell button module is connected in series with a transformer and a doorbell chime, which forms a doorbell circuit. The doorbell circuit is typically connected to a power source via the transformer connected to the AC power of the home. The home provides current to the transformer, which in turn provides current to the doorbell circuit. The doorbell chime can include an electromagnet and a bell.

When the push button in the doorbell button module is pressed, it closes the doorbell circuit. When the doorbell circuit is closed, current is supplied to the electromagnet in the doorbell chime. The current activates the electromagnet and generates a magnetic field, which attracts a metal arm or clapper attached to the electromagnet to the bell in the doorbell chime. The sound of the metal arm or clapper striking the bell produces the familiar ringing sound of a doorbell. The sound produced alerts the user that someone is at the door.

Although the aforementioned doorbell chime system is the traditional option, users have recently been replacing the existing doorbell button module associated with the doorbell chime system with a new kind of doorbell button module. In order to install the new doorbell button module, the existing doorbell button module is disconnected from the doorbell circuit and the new doorbell button module is wired into the doorbell circuit. Specifically, the new doorbell button module can be connected to the transformer and the doorbell chime in the doorbell circuit.

The new kind of doorbell button module can be the doorbell device disclosed herein. The doorbell device can include a doorbell button for a visitor to press, an energy storage device, a controller, and features like cameras and microphones to assist in monitoring the outside of the home. When the doorbell button in the doorbell device is pressed, the controller in the doorbell device may allow current to flow through the doorbell circuit to the electromagnet in the doorbell chime. As previously mentioned, the current could activate the electromagnet and attract it to the bell, producing the familiar ringing sound of a doorbell. However, the features of doorbell device, such as the controller, cameras, and microphones may not be able to operate on the current. The electromagnet in a doorbell chime typically only requires a few hundred mA to activate, but the doorbell device may not be able to operate at such a low current flowing through the doorbell circuit. The energy storage device in the doorbell device may be able to provide additional power to the doorbell device features. However, the energy storage device must be frequently removed from the doorbell device and recharged.

It could be possible for the controller of the doorbell device to harvest current from the doorbell circuit to charge the energy storage device when the doorbell button is being pressed. Unfortunately, however, if the doorbell device draws too much current through the doorbell circuit, the current could trigger the doorbell chime to start ringing, or worse the current could burn out the doorbell circuit. Both of these results could result in a poor user experience and could be unsatisfactory.

The present disclosure provides a mechanism to address these and possibly other issues. Namely, the disclosure provides a mechanism for a doorbell device to determine how much current a doorbell device can draw through a doorbell circuit without triggering the doorbell chime, particularly to determine the maximum such current that the doorbell device can draw without triggering the doorbell chime, and for the doorbell device to then automatically configure itself to draw the determined level of current for purposes of efficiently and quickly charging its energy storage device.

This arrangement has multiple benefits. For example, the doorbell device can be more affordable to manufacture. Because a doorbell chime is already present, the doorbell device does not need to include features to replicate the chime sound. The doorbell device disclosed herein can also have reduced cost and time associated with installation. The user only needs to change their doorbell module, and does not need to make any changes to the doorbell chime which may be housed within the walls of the home. Finally, the doorbell device can allow the user to keep the traditional doorbell chime sound originally installed in the home.

In addition, other example embodiments can leverage the use of the maximum amount of current harvested to determine how often the doorbell can be rung without draining the energy storage device of the doorbell device, as well as other operations such as limiting the times when the doorbell can be rung.

### II. Example Architecture

### A. Doorbell Circuit

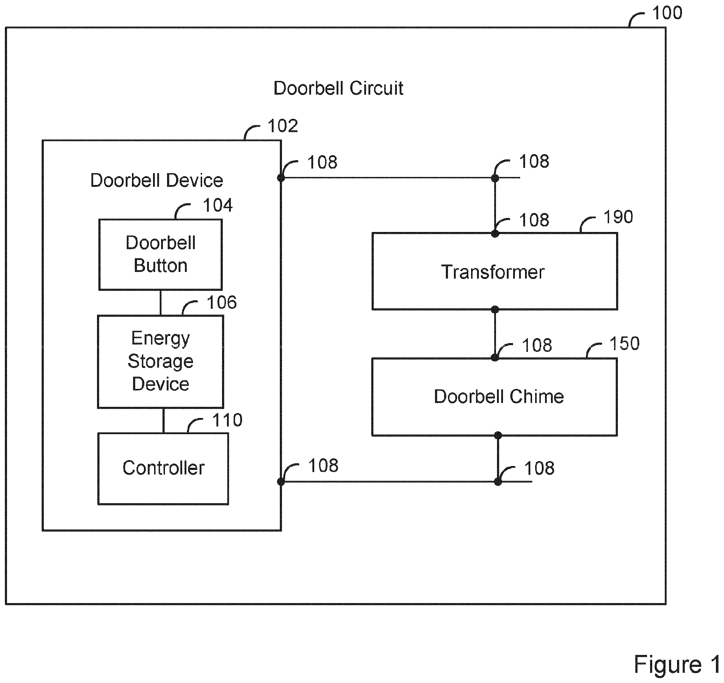

Figure 1 is a simplified block diagram of an example doorbell circuit 100. Generally, the doorbell circuit 100 can be used to alert a user of a visitor. This is accomplished using both an existing doorbell chime 150 and a doorbell device 102. Typically, to incorporate the doorbell device into the doorbell circuit with the existing doorbell chime, the existing doorbell button module is removed and replaced with the doorbell device, which includes a doorbell button and other features. As previously discussed, the doorbell device can be a new doorbell button module.

Specifically, to incorporate the doorbell device into the doorbell circuit the existing doorbell button module is disconnected from the transformer and the doorbell chime. In place of the existing doorbell button module, the doorbell device is connected to the transformer and the doorbell chime to complete the doorbell circuit. When the doorbell button in the doorbell device is pressed, current may flow through the doorbell circuit. The current can activate an electromagnet in the doorbell chime, which may strike the bell in the doorbell chime, producing the familiar doorbell chime sound. Furthermore, when the doorbell button in the doorbell device is pressed the camera in the doorbell device may activate. This configuration allows the user to use their existing doorbell chime and also have the benefits that are associated with the doorbell device.

As previously mentioned, the doorbell device may be connected to the house power source via the transformer. The transformer may be a limiting factor on how much power the doorbell device can draw from the source. The doorbell device may use approximately .5 mW in standby, and 1.312 W when actively transmitting a video. However, the doorbell should not draw so much power that the current associated with it would activate the doorbell chime. In some scenarios the doorbell device could draw anywhere from 10 mW to 150 mW of power without activating the doorbell chime. In a typical home, where the supplied voltage is 120 V, this could translate to .00008 mA to 1.25 mA. However, the doorbell device may be able to draw more current without activating the doorbell chime, in order to store power for later use.

Although the transformer may be rated for approximate 800 mA at the supplied voltage from the house power source, the doorbell device should not draw over a threshold current that could activate the doorbell chime when the doorbell button is not being pushed. Doorbell chimes typically only require about a few hundred mA to activate. However, the doorbell device may need a greater amount to current to operate all of its features. In an example embodiment, the doorbell device can include features like a camera, microphone, speaker, and internet connectivity. The doorbell device can provide real-time video and audio feeds, motion detection, and two-way communication, and often integrate with other smart home devices for enhanced security and convenience. It can offer features such as video recording, live streaming, facial recognition, and the ability to receive notifications or alerts when someone is at the door, even when the user is not physically present at home. These features require greater power than what can be provided by the transformer alone.

To provide additional power to the doorbell device's features, the doorbell device can utilize an energy storage device. Typically, the energy storage device must be removed from the doorbell device and recharged on a regular basis. However, needing to frequently remove and charge the energy storage device can detrimentally affect user experience. As previously discussed, to address this problem, the doorbell device could harvest some of the current drawn through the doorbell circuit, using that current to charge the doorbell device energy storage device. The doorbell device could harvest a constant amount of power over time to account for the short bursts of peak power the doorbell device needs when it is activated. Example methods herein include determining how much current the energy storage device of the doorbell device can harvest through the doorbell circuit without activating or burning out the doorbell chime, and automatically configuring the doorbell device to harvest the determined amount of current. By accomplishing this, the energy storage device may not need to be removed as often, if at all, in order to charge it.

Returning to Figure 1, the doorbell device 102, the transformer 190, and the doorbell chime 150 are all electrically connected in series. Electrical connectors 108 are configured to electrically connect the doorbell device 102 in the doorbell circuit 100 with the doorbell chime 150 and the transformer 190. Transformer 190 is configured to provide current to the doorbell circuit 100 from the home's AC power. Transformer 190 typically steps down the voltage from 120 volts to anywhere from 24 to 18 volts.

When doorbell button 104 is depressed, enough current may be drawn through the doorbell circuit 100 to activate doorbell chime 150. Further, in accordance with the present disclosure, when doorbell button 104 is not depressed, current may flow through the doorbell circuit 100 to charge the energy storage device 106, but the current would not be enough to activate the doorbell chime 150. The energy storage device 106 may provide energy to drive features of the doorbell, such as controller 110.

In an example embodiment, the doorbell circuit 100 is in a closed state. To charge the energy storage device 106, the processor may allow current to continuously run through the doorbell circuit 100. When the doorbell button 104 is not being pressed, the processor 112 allows a limited current through the doorbell circuit 100 to charge the energy storage device 106. This limited current is enough current to charge the energy storage device 106, but not enough current to activate the electromagnet 152 in the doorbell chime 150. When the doorbell button 104 has been pressed, the processor 112 will allow the full current through the doorbell circuit 100 so that the doorbell chime 150 rings.

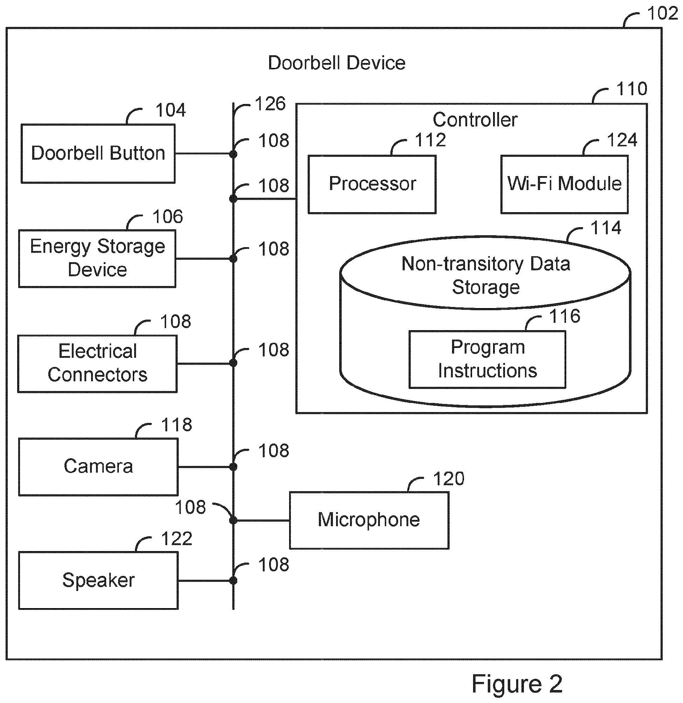

Figure 2 is a simplified block diagram of the example doorbell device 102. The doorbell device 102 can include various components such as doorbell button 104, energy storage device 106, electrical connectors 108, controller 110, camera 118, microphone 120, and/or speaker 122. The doorbell device 102 can also include one or more connection mechanisms that connect various components within the doorbell device 102. For example, the doorbell device 102 can include the connection mechanism represented by the line 126 connecting the above-referenced components of the doorbell device 102, as shown in Figure 2. The doorbell device can be used to alert a user of a visitor, obtain an image of the visitor, obtain audio from the visitor, and/or allow audio communication with the visitor.

When the doorbell button 104 is depressed, the processor 112 allows enough current to flow through doorbell circuit 100, causing the doorbell chime 150 to make a sound. The doorbell button 104 can also trigger other features in doorbell device 102. For example, depressing the doorbell button 104 can cause camera 118 to start recording. The doorbell button 104 could take on many different shapes and sizes, and could also be illuminated.

The energy storage device 106 could be any type of energy storage device suitable for operation. For example, the energy storage device can be or include a rechargeable battery, including a nickel-metal hydride (NiMH) battery, nickel-cadmium (NiCd) battery, lithium-ion (Li-ion) battery, lithium-polymer (LiPo) battery, nickel-zinc (NiZn) battery, and/or a solid-state battery. Alternatively, the energy storage device can be or include a super capacitor. The energy storage device 106 is configured to provide energy to drive the doorbell device 102. For example, energy from the energy storage device 106 can power the different features within doorbell device 102.

The camera 118 can enable visual monitoring and communication with visitors at the door. The camera 118 can capture live video footage of the door's surroundings and send the footage to a user's mobile device, allowing the user to see and interact with anyone who approaches or rings the doorbell device 102. The camera 118 can also include motion detection capabilities. The camera 118 may continuously monitor the area surrounding the doorbell device 102 for movement. When motion is detected, the camera 118 can trigger an event and send real-time notifications to the user's mobile device. The motion detection feature allows users to be alerted when a visitor approaches their doorstep, providing an added layer of security and convenience.

In an example embodiment, the camera 118 is integrated into the doorbell device 102 and is equipped with features such as high-definition resolution, wide-angle lenses, and night vision capabilities to ensure clear and detailed visuals, even in low-light conditions. In an alternative embodiment the camera could be located external to the doorbell device 102. This may allow the camera to capture a better angle. In this embodiment the camera may be in wireless communication with the doorbell device 102. In either example embodiment, the user may be able to remotely access the camera feed, view the live video stream, and review recorded footage through a connected mobile app or other compatible devices.

The camera 118 could be a fixed lens camera, an adjustable lens camera, an infrared camera, a high-definition camera, a wide dynamic range camera, and/or a fisheye camera, among other possibilities.

The microphone 120 can enable audio monitoring and communication with visitors at the door. The microphone 120 and the speaker 122 can enable two-way communication between the user and the visitor at the door. The microphone 120 captures visitor audio that can be remotely played for the user through a mobile device's connected mobile app or other compatible devices. The user could then record a message to the visitor using the mobile device's microphone. The speaker 122 in the doorbell device 102 may play the user's message for the visitor. The speaker 122 can also provide voice prompts and alerts for notifications and announcements to visitors. In an example embodiment, the speaker 122 can be at least one of an integrated speaker, an external speaker, and/or an amplified speaker, among other possibilities.

When a visitor rings the doorbell button 104 or triggers a motion detection event through the camera 118, the microphone 120 can capture the visitor's voice or other sounds. The processor 112 can transmit audio data including the visitor's voice or other sounds to the user's device, to which the user can respond to in real-time. This functionality may allow the user to have real-time conversations with the visitor. For example, the user can receive instructions from the visitor, or give directions to the visitor. The user can even use this functionality to deter mischief by making the user's knowledge of the visitor's presence known.

The microphone 120 could be an electret condenser microphone, a micro-electro-mechanical systems microphone, and omnidirectional microphone, a directional microphone, and/or a noise-cancelling microphone, among other possibilities.

As further illustrated in Figure 2, the doorbell device 102 could include a controller 110. The controller 110 includes at least one processor 112, at least one analog to digital converter, and a memory. The memory may include a computer readable medium. The computer readable medium may be a non-transitory data storage 114, which may include, without limitation, read-only memory (ROM), programmable read-only memory (PROM), erasable programmable read-only memory (EPROM), electrically erasable programmable read-only memory (EEPROM), non-volatile random-access memory (e.g., flash memory), a solid state drive (SSD), a hard disk drive (HDD), a Compact Disc (CD), a Digital Video Disk (DVD), a digital tape, read/write (R/W) CDs, R/W DVDs, etc. Other types of storage devices, memories, and media are also included herein.

The non-transitory data storage 114 may also store a set of program instructions 116. The program instructions 116 are executable by the processor 112 to perform various operations, such as the operations described in this disclosure. The at least one processor 112 can include one or more processors, such as one or more general-purpose microprocessors and/or one or more special purpose microprocessors. The one or more processors may include, for instance, an application-specific integrated circuit (ASIC) or a field-programmable gate array (FPGA). Other types of processors, computers, or devices configured to carry out software instructions are also contemplated herein.

The controller 110 may also include a Wi-Fi module 124. The Wi-Fi module 124 can enable the doorbell device 102 to have internet connectivity. The processor 112 may provide instructions to the Wi-Fi module 124. During the setup process, the user can configure the doorbell device 102 to connect to the user's home Wi-Fi network by providing the network name (SSID) and password. Internet connectivity may allow users to remotely monitor and interact with visitors through a mobile app on their smartphones or other connected devices

The electrical connectors 108 electrically connect the doorbell device 102 in the doorbell circuit 100 with doorbell chime 150 and transformer 190. The electrical connectors 108 may facilitate the current flowing through the doorbell circuit 100. They may also facilitate the transmission of power, signals, and data for the functioning of the doorbell device 102, and doorbell circuit 100 as a whole. The electrical connectors 108 also electrically connect the components within doorbell device 102 to each other.

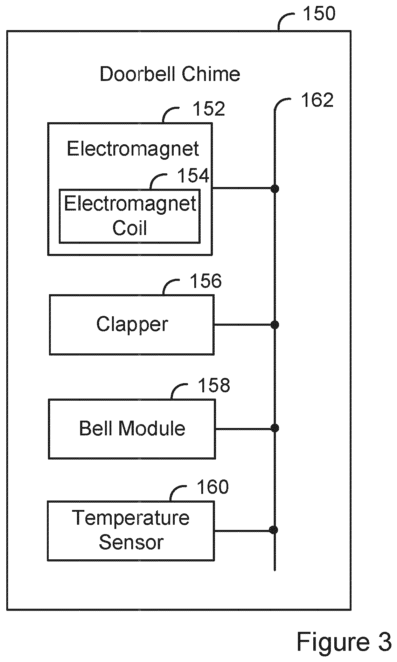

Figure 3 is a simplified block diagram of the example doorbell chime 150. The doorbell chime 150 can include various components such as electromagnet 152, clapper 156, bell module 158, and temperature sensor 160. The doorbell chime 150 can also include one or more connection mechanisms that connect various components within the doorbell chime 150. For example, the doorbell chime 150 can include the connection mechanism represented by the line 162 connecting the above-referenced components of the doorbell chime 150, as shown in Figure 3.

In an example embodiment, the doorbell chime 150 may be an electro-mechanical device, which combines electrical components with mechanical elements to produce sound. Typically, the doorbell chime 150 operates as follows: when the doorbell button is pressed the processor allows approximately 100 mA of current to flow through the doorbell circuit. The current can be enough to activate an electromagnet and create a magnetic field. The energized electromagnet can attract a metal clapper, causing the clapper to pivot or swing forward and strike against a bell. The impact creates the desired chime sound. Releasing the button breaks signals the processor to cease sending the approximately 100 mA of current and allows the hammer to return to its original position through a spring or gravity. These electro-mechanical doorbell chimes typically operate on low voltage, often 8-24 volts, provided by a transformer connected to the home power supply.

The electromagnet 152 can include an electromagnet coil 154. In an example embodiment, the electromagnet 152 includes multiple loops of wire (i.e., the electromagnet coil 154) wound around a core material. The core material is a ferromagnetic material, typically iron or steel. When current flows through the electromagnetic coil 154, it creates a magnetic field. This magnetic field is generated due to the interaction between the electric current and the wire.

One embodiment of the doorbell chime 150 includes a temperature sensor 160. The temperature sensor 160 can be used to monitor the temperature of the electromagnet coil 154. Therefore, the temperature sensor 160 may be placed near or on the electromagnet coil 154. In an example embodiment, the temperature sensor 160 may be at least one of a thermocouple, a resistance temperature detector, a thermistor, an integrated circuit temperature sensor and/or an infrared sensor. The temperature of the electromagnet coil 154 could also be monitored by a device outside of the doorbell chime 150. For example, an external infrared sensor could monitor the temperature. The infrared sensor could be part of a different device.

The clapper 156 may be the element that strikes the bell module 158 within the doorbell chime 150. In one embodiment, clapper 156 may be spring-loaded. The clapper 156 may be made from a metal material, and in one embodiment the clapper 156 may be made from a magnetic material, such as iron or steel. The clapper may take on many shapes, including a paddle shape, a long thin shape, and/or an arm with a hammer at the end. The clapper 156 may be alternatively referred to as a hammer, a striker, a plunger, or an arm.

The doorbell chime 150 may also include bell module 158, which makes the familiar doorbell noise. For example, when the clapper 156 strikes it, the bell module 158 may make the doorbell sound. In one embodiment, the bell module 158 is made from a metal material. Particularly, the material for the bell module 158 could be magnetic in order to attract the electromagnet. The bell module 158 may include any of a tone bar, a chime, or a gong.

In an example embodiment, the electromagnet 152 can be connected to the clapper 156, so that when the magnetic field is generated, the clapper 156 is attracted to the bell module 158. In an alternative embodiment, the electromagnet 152 can be connected to the bell module 158, so that when the magnetic field is generated, the clapper 156 is attracted to the bell module 158.

In some instances, the doorbell circuit 100 can include multiple instances of at least some of the described components.

### B. Computing System

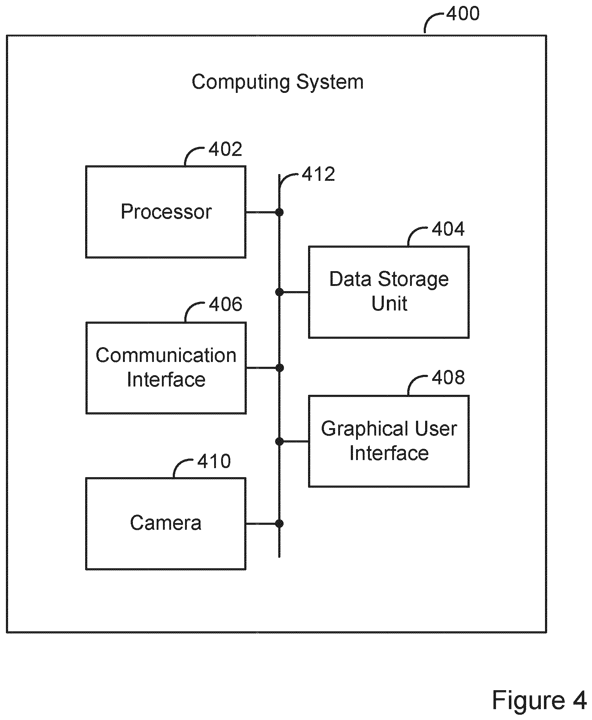

Figure 4 is a simplified block diagram of an example computing system 400. In an example embodiment, the computing system 400 can be a mobile device. The mobile device may be used to communicate with the doorbell device 102. In another embodiment, the computing system could be a remote computer. The computing system 400 can be configured to perform and/or can perform various operations, such as the operations described in this disclosure. The computing system 400 can include various components, such as a processor 402, a data storage unit 404, a communication interface 406, a graphical user interface 408, and/or a camera 410.

The processor 402 can be or include a general-purpose processor (e.g., a microprocessor) and/or a special-purpose processor (e.g., a digital signal processor). The processor 402 can execute program instructions included in the data storage unit 404 as described below.

The data storage unit 404 can be or include one or more volatile, non-volatile, removable, and/or non-removable storage components, such as magnetic, optical, and/or flash storage, and/or can be integrated in whole or in part with the processor 402. Further, the data storage unit 404 can be or include a non-transitory computer-readable storage medium, having stored thereon program instructions (e.g., compiled or non-compiled program logic and/or machine code) that, upon execution by the processor 402, cause the computing system 400 and/or another computing system to perform one or more operations, such as the operations described in this disclosure. These program instructions can define, and/or be part of, a discrete software application.

In some instances, the computing system 400 can execute program instructions in response to receiving an input, such as an input received via the communication interface 406 and/or the graphical user interface 408. The data storage unit 404 can also store other data, such as any of the data described in this disclosure.

The communication interface 406 can allow the computing system 400 to connect with and/or communicate with another entity according to one or more protocols. Therefore, the computing system 400 can transmit data to, and/or receive data from, one or more other entities according to one or more protocols. In one example, the communication interface 406 can be or include a wired interface, such as an Ethernet interface or a High-Definition Multimedia Interface (HDMI). In another example, the communication interface 406 can be or include a wireless interface, such as a cellular or WI-FI interface.

The graphical user interface 408 can allow for interaction between the computing system 400 and a user of the computing system 400. For example, the user can send instructions and receive feedback via the graphical user interface 408. As such, the graphical user interface 408 can be or include an input component such as a keyboard, a mouse, a remote controller, a microphone, and/or a touch-sensitive panel. The graphical user interface 408 can also be or include an output component such as a display screen (which, for example, can be combined with a touch-sensitive panel) and/or a sound speaker.

The camera 410 can be any type of camera and/or related components, configured to capture and image and/or video content data.

The computing system 400 can also include one or more connection mechanisms that connect various components within the computing system 400. For example, the computing system 400 can include the connection mechanisms represented by lines 412 that connect components of the computing system 400, as shown in Figure 4.

The computing system 400 can include one or more of the above-described components and can be configured or arranged in various ways. For example, the computing system 400 can be configured as a server and/or a client (or perhaps a cluster of servers and/or a cluster of clients) operating in one or more server-client type arrangements, such as a partially or fully cloud-based arrangement, for instance.

In some cases, the computing system 400 can take the form of a different and/or more specific type of computing system, such as a desktop or workstation computer, a laptop, a tablet, a television, a set-top box, a media player, and/or a head-mountable display device (e.g., virtual-reality headset or an augmented-reality headset), among numerous other possibilities.

### III. Example Operations

The doorbell circuit 100, the controller 110, and/or components of either can be configured to perform and/or can perform various operations. As noted above, the processor 112 can perform operations related to determining the maximum doorbell circuit current that can be drawn through the doorbell circuit 100 without activating the doorbell chime 150, and configuring the doorbell device 102 to draw the determined maximum doorbell circuit current through the doorbell circuit 100. These and related operations will now be described in the context of the example embodiments.

### A. Example Embodiments

In one example embodiment, determining the maximum doorbell circuit current that will not activate the doorbell chime 150, and configuring the doorbell device 102 to draw the determined maximum doorbell circuit current through the doorbell circuit 100 can involve (1) drawing a current through the doorbell circuit 100, (2) while drawing the current through the doorbell circuit 100, determining a maximum doorbell circuit current that will not activate the doorbell chime 150, and (3) based on determining the maximum doorbell circuit current that will not activate the doorbell chime 150, configuring the doorbell device 102 to draw the determined maximum doorbell circuit current through the doorbell circuit 100. Determining the maximum doorbell circuit current that will not activate the doorbell chime can include: (i) determining whether the current being drawn through the doorbell circuit 100 has activated the doorbell chime 150, (ii) in response to determining that the current being drawn through the doorbell circuit 100 has activated the doorbell chime 150, decrementing the current drawn through the doorbell circuit 100, (iii) in response to determining that the current being drawn through the doorbell circuit 100 has not activated the doorbell chime 150, incrementing the current drawn through the doorbell circuit 100.

To begin, the doorbell device 102, specifically the processor 112, can cause a current to be drawn through the closed doorbell circuit 100 from the transformer 190. The processor 112 controls the flow of current through the doorbell circuit 100 by utilizing electronic switches such as transistors. These switches, under the control of the processor 112, can selectively open and close pathways within the doorbell circuit 100. When a pathway is closed, it creates a complete loop for the current to flow. By manipulating these switches in a coordinated manner, the processor 112 can regulate the timing, duration, and intensity of the current flow. The current could be a steady alternating current, which is drawn through the doorbell circuit 100 to charge the energy storage device 106.

Example embodiments herein provide a way to determine the maximum amount of doorbell circuit current that can be drawn to charge the energy storage device 106, without activating the doorbell chime 150. In one embodiment, the maximum doorbell circuit current is a constant amount over time that only changes when the doorbell button 104 is pushed. In an alternative embodiment, the maximum doorbell circuit current that can be drawn through the doorbell circuit 100 without activating the doorbell chime 150 is a maximum over time. The doorbell circuit current drawn through the doorbell circuit 100 can be drawn based on a duty cycle. In other words, the doorbell circuit current would be pulsed. The doorbell device 102 could draw the full current from the transformer for 10 milliseconds and then draw no current for 10 milliseconds. In an example embodiment, the current could be drawn on a 60 Hz duty cycle. The period of 60 Hz is 16.67 milliseconds. The doorbell device 102 could draw the full current for 2 milliseconds of the 60 Hz duty cycle. Although the electromagnet 152 may begin to activate, the activation is for such a short period of time that the electromagnet 152 cannot overcome its own inertia. Therefore, it may not strike the bell module 158.

While drawing the current through the doorbell circuit 100, the processor 112 of the doorbell device 102 can determine a maximum doorbell circuit current that will not activate the doorbell chime 150. At the maximum doorbell circuit current, the processor 112 will not allow enough current to be drawn to activate the doorbell chime 150, as long as the doorbell button 104 is not being pushed. Activating the doorbell chime 150 could be detrimental to the user experience. Additionally, over activating the doorbell chime 150 could cause the doorbell chime 150 to burn out. However, to charge the energy storage device 106 as quickly as possible, the maximum doorbell circuit current that will not activate the doorbell chime 150 should be used. By charging the energy storage device 106 with current drawn through the doorbell circuit 100, the user may not need to remove the energy storage device 106 from the doorbell device 102 to recharge the energy storage device 106.

In order to determine the maximum doorbell circuit current that will not activate the doorbell chime, first the processor 112 could determine how much current will activate the doorbell chime 150. Activating the doorbell chime 150 occurs when the current drawn through the doorbell circuit 100 activates the electromagnet 152 in the doorbell circuit 100. When the electromagnet 152 is activated, it is attracted to the bell module 158 in the doorbell chime 150 and the chime is rung. Once the processor 112 has determined at what current the doorbell chime 150 is activated, the processor 112 can work backward and determine a next lowest current that would not activate the doorbell chime 150. And the processor 112 could deem that next lowest current to be the maximum doorbell circuit current that will not activate the doorbell chime 150.

Determining whether the current being drawn through the doorbell circuit 100 has activated the doorbell chime 150 can be accomplished in multiple ways. In one embodiment, determining whether the current being drawn through the doorbell circuit has activated the doorbell chime includes detecting a change in voltage across the doorbell circuit. In an example embodiment, the processor can incrementally step up the current that goes through the doorbell circuit by 5 mA per step. When there is enough current flowing through the doorbell circuit 100, the electromagnet 152 in the doorbell chime 150 is activated. This activation in the doorbell chime 150 results in the change in voltage across the doorbell circuit 100. The processor 112 can detect this change in the system.

The processor 112 can detect the change in voltage across the doorbell circuit 100 by utilizing analog-to-digital converters (ADCs) or voltage monitoring circuits. ADCs convert analog voltage signals into digital values that can be processed by the processor 112. By periodically sampling the voltage at specific points in the circuit, the processor 112 can monitor changes in voltage levels. These sampled values are then compared to predefined thresholds or analyzed using algorithms to detect voltage variations. Additionally, voltage monitoring circuits can directly interface with the processor 112 to provide voltage level information.

In another embodiment, determining whether the current being drawn through the doorbell circuit 100 has activated the doorbell chime 150 includes providing the user instructions during set up of the doorbell device 102. The instructions may come in the box with the doorbell device 102 and may direct the user to open a software application on their mobile device during set up of the doorbell device 102. The software application can be used with the doorbell device to receive notifications of a visitor, and can also be used during the set-up process. The processor 112 can gradually step up the current supplied to the doorbell circuit 100. At predetermined increments in the current increase, computing system 400 may send an instruction to the user, through the software application on the mobile device, to listen for a doorbell chime sound. The processor 112 may receive feedback from the user via the software application which is displayed by a graphical user interface (GUI) on the mobile device. In an example embodiment, the feedback is either that the doorbell chime sound was activated or that the doorbell chime sound was not activated. If the doorbell chime sound was not activated, then based at least on that feedback, the processor 112 can continue to step up the current. If the doorbell chime sound was activated, then based at least on that feedback, the processor may gradually decrement the current to pinpoint the maximum current more accurately.

In another embodiment, determining whether the current being drawn through the doorbell circuit has activated the doorbell chime includes detecting a change in inductance across the doorbell circuit. The change in inductance can occur upon activation of the doorbell chime. The change in inductance can be determined by measuring the properties of an inductor in the doorbell circuit. The properties of the inductor can be measured using an inductive proximity sensor, an LC resonance circuit, or an inductance bridge circuit. The properties of the inductor can also be measuring using testing such as testing for a transformer winding inductance change, eddy current testing, or testing for a change in magnetic field coupling.

In another embodiment, determining whether the current being drawn through the doorbell circuit has activated the doorbell chime includes detecting a change in resistance across the doorbell circuit, where the change in resistance across the doorbell circuit occurs upon activation of the doorbell chime. The processor 112 may gradually increment the current supplied to the doorbell circuit 100. The processor 112 may also monitor the current and voltage. The processor 112 can monitor changes in voltage and current across the doorbell circuit 100 by utilizing analog-to-digital converters (ADCs) and current sensing techniques. ADCs convert analog voltage and current signals into digital values that the processor 112 can interpret. By connecting voltage and current sensors to specific points in the doorbell circuit 100, the processor 112 can measure the voltage and current levels at those locations. These measurements are then sampled and converted into digital data, allowing the processor 112 to analyze and track variations over time. By continuously monitoring these values, the processor 112 can detect changes in voltage and current.

If there is a change in current and/or voltage, it is likely that copper wires within the doorbell circuit 100 are heating up and increasing the resistance of the wires. Increased resistance, and temperature, of the wires is a warning sign that the doorbell circuit 100 may be close to burning out. In an example embodiment, if the voltage is staying the same, but the current is dropping, the resistance of the wires is increasing. Similarly, if the current is staying the same, but the voltage is increasing, the resistance of the wires is increasing. When this occurs, the current is likely too high and there is a risk that the doorbell circuit 100 could burn out. Therefore, the current should be decremented to try to stabilize the doorbell circuit 100.

In one embodiment, detecting the change in resistance across the doorbell circuit can include detecting a temperature change in the electromagnet coil 154 in the doorbell circuit 100. If the change in temperature is over a predetermined threshold, the current is likely over the maximum and should be decremented to avoid damaging the doorbell circuit 100. Excessive heat could fry the doorbell circuit 100, therefore it may be desirable to have the temperature stay below such a threshold.

The temperature, and change therein, can be detected by monitoring the temperature of the electromagnetic coil 154 with the temperature sensor 160. As previously stated, the temperature sensor 160 could be placed near or on the electromagnet coil 154. For example, the temperature sensor 160 could be a resistance temperature detector made from a material like platinum and either attached to the surface of the electromagnet coil 154 or embedded within the coil windings.

In an alternative embodiment, the temperature sensor 160 does not need to be internal to the doorbell circuit 100. The doorbell device 102 may be part of an Internet of Things (IoT) ecosystem, which could include devices with external infrared sensors. A device that is proximate to the doorbell circuit 100 can use its infrared sensor to monitor the temperature of the electromagnet coil 154. The infrared sensor could and could detect any temperature change in the electromagnetic coil 154. The temperature information can be sent from the device to the doorbell device 102 over the internet.

In another embodiment, determining whether the current being drawn through the doorbell circuit 100 has activated the doorbell chime 150 includes detecting, with the microphone 120, a doorbell chime sound. While incrementing the current, the processor 112 could receive an audio feed from the microphone 120 to determine whether the chime sound has occurred. If the chime sound has occurred, the current has reached a level that would activate the electromagnet 152. Additionally, the processor 112 could receive footage from camera 118. With the footage, the processor 112 could confirm that the doorbell button 104 was not pushed by a visitor, therefore validating the results.

In an example implementation, machine learning could be used as a basis to determine whether the current being drawn through the doorbell circuit 100 has activated the doorbell chime 150. For example, a machine learning model may be trained to determine what model/type of doorbell chime is in the home based on various characteristics of the doorbell chime. Once the model/type of the doorbell chime is determined, the doorbell device can use an associated maximum current setting. If the current being drawn through the doorbell circuit 100 is over the maximum current setting, then it is likely that the doorbell chime 150 has been activated.

In this implementation, the computing system 400 or another computing system substantially similar to computing system 400 could train a machine learning model based on doorbell data stored at a central server. The doorbell data that the machine learning model is trained on could include classifications of doorbell chimes, based characteristics of the doorbell chime. The doorbell chimes could be classified together as a certain type of doorbell chime based on similar characteristics. The characteristics could include at least one of a doorbell chime sound, a doorbell chime timing, a geographic location of the doorbell chime, or age of the doorbell chime. The doorbell chime sound could be the familiar bell sound that is produced by the doorbell chime. The doorbell chime timing may be the time between chime sounds issued by the doorbell chime. The geographic location of the doorbell chime may be the neighborhood or subdivision of the home that the doorbell chime is installed in. The age of the doorbell chime could include the year that the doorbell chime was manufactured, or the age of the home that the doorbell chime is installed in.

Each classification of a certain type of doorbell chime also includes an associated predetermined current to use as the maximum doorbell circuit current. For each classification of certain types of doorbell chimes the maximum current has already been determined. The classifications of certain types of doorbell chimes, including the associated doorbell characteristics and the predetermined maximum currents, could be used to train the machine learning model.

To gather data used for training, a plurality of doorbell devices and/or a plurality of IoT devices at multiple homes could gather the doorbell chime sound and the doorbell chime timing for the doorbell chime at each of the multiple homes. The maximum current for each of the doorbell chimes at the multiple homes may already be known, or may be determined using the method disclosed herein. That maximum current could then be associated with the respective doorbell chime in the data gathered for training.

In an additional embodiment, geographic location of each of the doorbell chimes in multiple homes, or age of each of the doorbell chimes in the multiple homes could also be used to classify doorbell chimes in order to assign maximum currents. For example, homes within the same subdivision may have been built using the same or similar doorbell chimes. Additionally, homes of similar ages may also have similar doorbell chimes. The maximum current for each of the doorbell chimes at the multiple homes may already be known, or may be determined using the method disclosed herein.

Once the machine learning model is trained based on the doorbell data, the computing system 400 can determine, based on the trained machine learning model, a type of doorbell that the doorbell chime 150 is and a predetermined current associated with the type of doorbell being used. The microphone 120 could be used to listen to the doorbell chime sound, and the doorbell chime timing of the doorbell chime 150. The doorbell chime sound and/or doorbell chime timing could be used to classify the doorbell chime 150 as a type of doorbell with a known maximum current. Alternatively, microphones in other IoT devices could be used to listen to the doorbell chime 150 before the doorbell device 102 is even installed. That way, the type of doorbell chime the user has can be determined before installation, which would simplify completing the set-up process. In an additional embodiment, the user could provide the geographic location and/or age of the home via the aforementioned GUI of the mobile device. The computing system 400 could use the geographic location and/or age of the home to determine the type of doorbell the doorbell chime 150 is.

Based on the above determinations, the processor 112 can determine that the doorbell chime 150 has been activated if the current that is being drawn through the doorbell circuit 100 is greater than the predetermined current associated with the type of doorbell classification. Therefore, the processor 112 could conclude that the current being drawn through the doorbell circuit 100 is too high.

In response to determining that the current being drawn through the doorbell circuit 100 has activated the doorbell chime 150, the processor 112 can decrement the current drawn through the doorbell circuit 100. The current should be decremented in predetermined amounts, for example 5 mA at a time. The decrementing should continue until the current no longer activates the doorbell chime 150.

The example embodiment further includes in response to determining that the current being drawn through the doorbell circuit has not activated the doorbell chime, incrementing the current drawn through the doorbell circuit. Similar to decrementing, the current should be incremented in predetermined amounts, for example 0.5mA. The current should continue to be incremented until the doorbell chime 150 is activated. Once the doorbell chime 150 is activated, the current could be decremented until the doorbell chime 150 is no longer activated. That current may be set as the maximum doorbell circuit current. Alternatively, the maximum current could be set at the current level that was right before the doorbell chime 150 was activated.

Finally, once the processor 112 determines the maximum doorbell circuit current that will not activate the doorbell chime 150, the processor 112 can configure the doorbell device 102 to draw the determined maximum doorbell circuit current through the doorbell circuit 100. For example, the processor 112 can regulate the current drawn by controlling the operation of various components within the circuit, such as the energy storage device 106.

The processor 112 can regulate the current drawn through the doorbell circuit 100 so that the current does not surpass the determined maximum doorbell circuit current using a combination of monitoring and control mechanisms. For example, the processor 112 may continuously monitor various parameters of the energy storage device 106, such as its voltage, temperature, and state of charge. The processor 112 can also use a charging algorithm or control logic to calculate and adjust the charging current to the determined maximum doorbell circuit current. The processor 112 can further implement current regulation mechanisms to maintain the determined maximum doorbell circuit current. This may involve feedback control loops that monitor the actual charging current and adjust the charging circuitry to match the determined maximum doorbell circuit current.

Alternative embodiments for configuring the doorbell device 102 to draw the determined maximum doorbell circuit current through the doorbell circuit 100 can also include additional features such as adaptive charging algorithms, fast charging support, and communication interfaces to external devices or charging infrastructure.

As previously discussed, the current drawn through the doorbell circuit 100 can be used to charge the energy storage device 106. This way, the energy storage device 106 does not need to be removed from the doorbell device 102 and charged by the user. Instead, the energy storage device 106 can stay in the doorbell device 102 to charge. This can greatly improve and simplify the user's experience.

One embodiment may further include conserving energy storage device life by limiting the extent to which the doorbell device 102 will ring. The processor 112 may first determine the amount of energy storage device charge used for the doorbell device 102 to ring by estimating the power consumption of the various elements of the doorbell device 102. When the doorbell device 102 rings, it may use energy from the energy storage device 106 to operate features like the camera 118, microphone 120 and/or controller 110. That amount of energy storage device charge required to operate those features may be an energy storage device threshold. The processor 112 may determine that the energy storage device's energy level should not go below the energy storage device threshold, so as to help ensure that the energy storage device always has enough energy to facilitate activating the doorbell chime 150. The processor 112 may also determine, based on the maximum doorbell circuit current that can be drawn through the doorbell circuit 100, an amount of time needed to charge the energy storage device to the energy storage device threshold. After the doorbell device 102 has been rung once, the processor 112 may limit the doorbell device's 102 ability to ring. The processor 112 may limit the doorbell device's 102 ability to ring for the time needed to charge the energy storage device 106 to the energy storage device threshold. This could prevent a visitor from ringing the doorbell device 102 multiple times in a row and draining the energy storage device 106.

### B. Example Methods

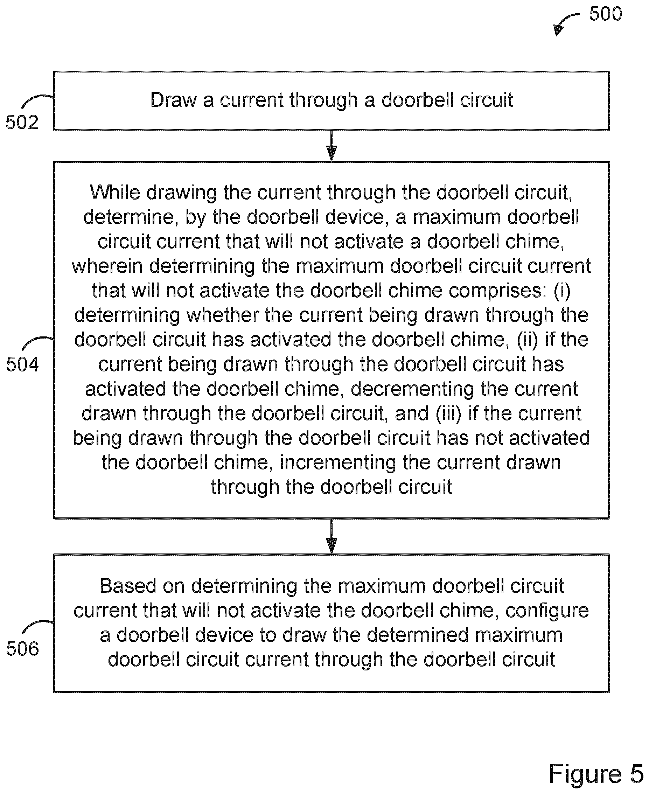

Figure 5 is a flow chart illustrating an example method 500. The method 500 can be carried out by the doorbell device 102. At block 502, the method 500 includes drawing a current through a doorbell circuit. At block 504 the method 500 includes while drawing the current through the doorbell circuit, determining, by the doorbell device, a maximum doorbell circuit current that will not activate a doorbell chime, wherein determining the maximum doorbell circuit current that will not activate the doorbell chime comprises: (i) determining whether the current being drawn through the doorbell circuit has activated the doorbell chime, (ii) if the current being drawn through the doorbell circuit has activated the doorbell chime, decrementing the current drawn through the doorbell circuit, (iii) if the current being drawn through the doorbell circuit has not activated the doorbell chime, incrementing the current drawn through the doorbell circuit. At block 506 the method 500 includes based on determining the maximum doorbell circuit current that will not activate the doorbell chime, configuring a doorbell device to draw the determined maximum doorbell circuit current through the doorbell circuit.

In some examples, determining whether the current being drawn through the doorbell circuit has activated the doorbell chime includes: (i) detecting a voltage across the doorbell circuit; (ii) stepping up the current drawn through the doorbell circuit in predetermined amounts; and (iii) detecting a change in the voltage across the doorbell circuit.

In additional examples, determining whether the current being drawn through the doorbell circuit has activated the doorbell chime includes: (i) sending an instruction to a user, via a graphical user interface (GUI) of a mobile device, to listen for a doorbell chime; and (ii) receiving feedback from the user via the GUI, where the feedback includes either that the doorbell chime was activated or that the doorbell chime was not activated.

In further examples, determining whether the current being drawn through the doorbell circuit has activated the doorbell chime includes: (i) training a machine learning model based on doorbell data stored at a central server; (ii) determining, based on the trained machine learning model, a type of doorbell being used and a predetermined current associated with the type of doorbell being used; and (iii) determining whether the current drawn through the doorbell circuit is the same as the predetermined current associated with the type of doorbell being used.

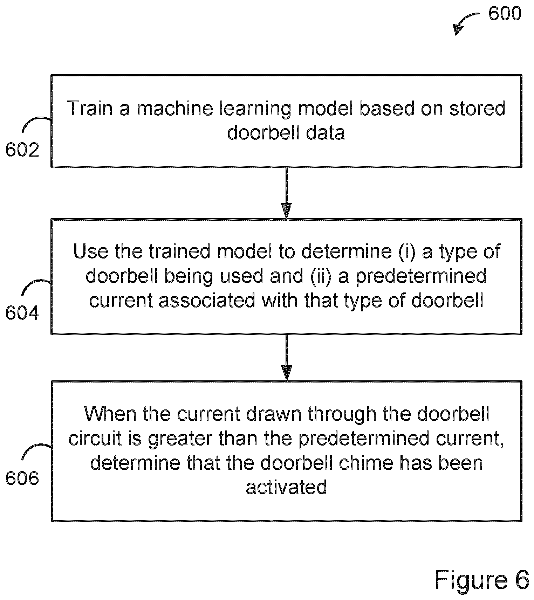

Figure 6 is a flow chart illustrating an example method 600 for determining whether the current being drawn through the doorbell circuit has activated the doorbell chime. At block 602, the method 600 includes training a machine learning model based on stored doorbell data. At block 604 the method 600 includes using the trained model to determine (i) a type of doorbell being used and (ii) a predetermined current associated with that type of doorbell. At block 606, the method 600 includes, when the current drawn through the doorbell circuit is greater than the predetermined current, determine that the doorbell chime has been activated.

### C. Other Related Concepts

In some instances, the doorbell circuit 100, computing system 400, or another entity can perform other operations to help operate the doorbell circuit 100. For example, after performing the operations disclosed above, the processor 112 can limit the doorbell device's 102 ability to ring. Using the GUI of the mobile device, the user can set a limit the rate at which the doorbell device 102 can be rung. For example, the doorbell device rings could be limited to three rings per minute, or one ring every ten seconds. Alternatively, the user can instruct the doorbell device 102 not to ring at all during certain times. Instead of ringing, push notifications may be sent to the user's mobile device to inform them that a visitor pressed the doorbell button 104. In these instances, instead of ringing and draining the energy storage device 106, the energy storage device 106 will continue to charge. The user's instructions can be communicated via the GUI of the user's mobile device to the controller 110. From there, the processor 112 can implement the user's instructions.

One embodiment may include implementing machine learning related to ring limitation. For example, a machine learning model could be trained to recognize certain people, such as police officers or package deliverers. In an example embodiment used to identify police officers, the machine learning model could be trained based on a diverse dataset containing images or videos of police officers. This dataset should include various angles, lighting conditions, and backgrounds to capture the variability in appearance. Using the dataset, a convolutional neural network (CNNs) could be used for the training. CNNs can be particularly effective for image recognition tasks. The model learns to identify features and patterns in the input data that distinguish police officers from other individuals. The machine learning model can be evaluated using separate validation and test datasets to assess its performance. Evaluation metrics such as accuracy, precision, recall, and F1 score are used to measure how well the model can correctly classify police officers. Once the model is deemed sufficiently accurate, it can be deployed by the doorbell device 102. The model can be integrated into a system or application that can process incoming images or videos, extract features from them, and utilize the trained model to predict whether the detected individuals are police officers or delivery drivers. The deployed model can be continuously monitored and refined to enhance its accuracy and adapt to new scenarios. This may involve retraining the model with additional data, fine-tuning its parameters, or incorporating user feedback to improve its performance over time.

The strategies detailed above can also be used to train the machine learning model to recognize package deliverers. In order to recognize package deliverers, the machine learning model could be trained based on a diverse dataset containing images or videos of package deliverers.

When the doorbell device 102 is set not to ring, the ring limitation may be overcome when the camera 118 views that a police officer is ringing the doorbell. Alternatively, the user could set a limit for the doorbell device 102 not to ring when the camera 118 views a package deliverer.

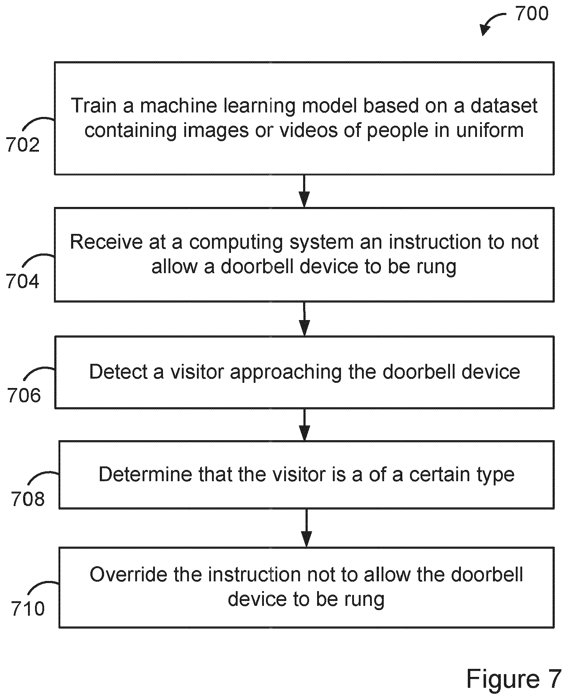

Figure 7 is a flow chart illustrating an example method 700. The method 700 can be carried out by the doorbell device 102. At block 702, the method 700 includes training a machine learning model based on a dataset containing images or videos of people in uniform. At block 704 the method 700 includes receiving at a computing system an instruction to not allow the doorbell device 102 to be rung. At block 706 the method 700 includes detecting a visitor approaching the doorbell device. At block 708 the method 700 includes determining that the visitor is of a certain type. At block 710 the method 700 includes overriding the instruction not to allow the doorbell device 102 to be rung.

### IV. Example Variations

Although some of the acts and/or functions described in this disclosure have been described as being performed by a particular entity, the acts and/or functions can be performed by any entity, such as those entities described in this disclosure. Further, although the acts and/or functions have been recited in a particular order, the acts and/or functions need not be performed in the order recited. However, in some instances, it can be desired to perform the acts and/or functions in the order recited. Further, each of the acts and/or functions can be performed responsive to one or more of the other acts and/or functions. Also, not all of the acts and/or functions need to be performed to achieve one or more of the benefits provided by this disclosure, and therefore not all of the acts and/or functions are required.

Although certain variations have been discussed in connection with one or more examples of this disclosure, these variations can also be applied to all of the other examples of this disclosure as well.

Although select examples of this disclosure have been described, alterations and permutations of these examples will be apparent to those of ordinary skill in the art. Other changes, substitutions, and/or alterations are also possible without departing from the invention in its broader aspects as set forth in the following claims.

## Claims

1. A doorbell device (102) comprising:
a doorbell button (104);
an energy storage device (106) configured to provide energy to drive the doorbell device;
electrical connectors (108) configured to electrically connect the doorbell device in a doorbell circuit (100) with a doorbell chime (150) and a transformer (190), wherein the transformer provides current to the doorbell circuit;
a controller (110) comprising at least one processor (112) and non-transitory data storage (114), wherein the non-transitory data storage stores program instructions (116) executable by the processor to cause the doorbell device to carry out operations including:
drawing a current through the doorbell circuit;
while drawing the current through the doorbell circuit, determining a maximum doorbell circuit current that will not activate the doorbell chime, wherein determining the maximum doorbell circuit current that will not activate the doorbell chime comprises:
(i) determining whether the current being drawn through the doorbell circuit has activated the doorbell chime,
(ii) in response to determining that the current being drawn through the doorbell circuit has activated the doorbell chime, decrementing the current drawn through the doorbell circuit,
(iii) in response to determining that the current being drawn through the doorbell circuit has not activated the doorbell chime, incrementing the current drawn through the doorbell circuit; and
based on determining the maximum doorbell circuit current that will not activate the doorbell chime, configuring the doorbell device to draw the determined maximum doorbell circuit current through the doorbell circuit.

2. The doorbell device of claim 1, wherein determining whether the current being drawn through the doorbell circuit has activated the doorbell chime comprises detecting a change in voltage across the doorbell circuit, wherein the change in voltage across the doorbell circuit occurs upon activation of the doorbell chime.

3. The doorbell device of claim 1, wherein activating the doorbell chime comprises the current drawn through the doorbell circuit activating an electromagnet in the doorbell circuit, wherein the electromagnet is attracted to the doorbell chime in the doorbell circuit.

4. The doorbell device of claim 1, wherein determining whether the current being drawn through the doorbell circuit has activated the doorbell chime comprises:
sending an instruction to a user, via a graphical user interface (GUI) of a mobile device, to listen for a doorbell chime sound; and
receiving feedback from the user via the GUI, wherein the feedback comprises either that the doorbell chime sound was activated or that the doorbell chime sound was not activated.

5. The doorbell device of claim 1, wherein determining whether the current being drawn through the doorbell circuit has activated the doorbell chime comprises detecting a change in resistance across the doorbell circuit, wherein the change in resistance across the doorbell circuit occurs upon activation of the doorbell chime.

6. The doorbell device of claim 5, wherein detecting the change in resistance across the doorbell circuit comprises detecting a temperature change in an electromagnet coil in the doorbell circuit.

7. The doorbell device of claim 6, wherein detecting the temperature change comprises monitoring a temperature of the electromagnet coil with an external infrared sensor.

8. The doorbell device of claim 6, wherein the doorbell circuit further comprises a temperature sensor, and wherein detecting the temperature change comprises monitoring the temperature of the electromagnet coil with the temperature sensor.

9. The doorbell device of claim 1, wherein the doorbell device further comprises a microphone, and wherein determining whether the current being drawn through the doorbell circuit has activated the doorbell chime comprises detecting, with the microphone, a doorbell chime sound.

10. The doorbell device of claim 1, wherein determining whether the current being drawn through the doorbell circuit has activated the doorbell chime comprises:
training a machine learning model based on doorbell data stored at a central server;
determining, based on the trained machine learning model, a type of doorbell being used and a predetermined current associated with the type of doorbell being used; and
determining that the doorbell chime has been activated when the current drawn through the doorbell circuit is greater than the predetermined current associated with the type of doorbell being used.

11. The doorbell device of claim 10, wherein the doorbell data comprises classifications of doorbell chimes based on at least one of a doorbell chime sound, a doorbell chime timing, a geographic location of the doorbell chime, or age of the doorbell chime, and wherein each classification is related to the predetermined current associated with the type of doorbell being used.

12. The doorbell device of claim 11, wherein the doorbell chime sound and the doorbell chime timing of the doorbell device are sensed by a plurality of Internet of Things (IoT) devices.

13. The doorbell device of claim 1, wherein the current drawn through the doorbell circuit is drawn based on a duty cycle, and wherein the maximum current comprises a maximum over time.

14. A method of configuring a doorbell device comprising:
drawing a current through a doorbell circuit;
while drawing the current through the doorbell circuit, determining, by the doorbell device, a maximum doorbell circuit current that will not activate a doorbell chime, wherein determining the maximum doorbell circuit current that will not activate the doorbell chime comprises:
(i) determining whether the current being drawn through the doorbell circuit has activated the doorbell chime,
(ii) if the current being drawn through the doorbell circuit has activated the doorbell chime, decrementing the current drawn through the doorbell circuit,
(iii) if the current being drawn through the doorbell circuit has not activated the doorbell chime, incrementing the current drawn through the doorbell circuit; and
based on determining the maximum doorbell circuit current that will not activate the doorbell chime, configuring the doorbell device to draw the determined maximum doorbell circuit current through the doorbell circuit.

15. A non-transitory computer-readable medium having computer-executable instructions stored thereon executable by at least one processor to cause a computing system to perform operations, comprising:
drawing a current through a doorbell circuit;
while drawing the current through the doorbell circuit, determining a maximum doorbell circuit current that will not activate a doorbell chime, wherein determining the maximum doorbell circuit current that will not activate the doorbell chime comprises:
(i) determining whether the current being drawn through the doorbell circuit has activated the doorbell chime,
(ii) in response to determining that the current being drawn through the doorbell circuit has activated the doorbell chime, decrementing the current drawn through the doorbell circuit,
(iii) in response to determining that the current being drawn through the doorbell circuit has not activated the doorbell chime, incrementing the current drawn through the doorbell circuit; and
based on determining the maximum doorbell circuit current that will not activate the doorbell chime, configuring a doorbell device to draw the determined maximum doorbell circuit current through the doorbell circuit.

## Patentansprüche

1. Türklingelvorrichtung (102), umfassend:
einen Türklingelknopf (104);
eine Energiespeichervorrichtung (106), die dazu konfiguriert ist, Energie bereitzustellen, um die Türklingelvorrichtung anzusteuern;
elektrische Verbinder (108), die dazu konfiguriert sind, die Türklingelvorrichtung in einer Türklingelschaltung (100) mit einer Türklingelglocke (150) und einem Transformator (190) elektrisch zu verbinden, wobei der Transformator Strom für die Türklingelschaltung bereitstellt;
ein Steuergerät (110), das mindestens einen Prozessor (112) und einen nichtflüchtigen Datenspeicher (114) umfasst, wobei der nichtflüchtige Datenspeicher Programmanweisungen (116) speichert, die durch den Prozessor ausführbar sind, um zu bewirken, dass die Türklingelvorrichtung Vorgänge durchführt, die Folgendes beinhalten:
Entnehmen eines Stroms durch die Türklingelschaltung;
während des Entnehmens des Stroms durch die Türklingelschaltung, Bestimmen eines maximalen Türklingelschaltungsstroms, der die Türklingelglocke nicht aktiviert, wobei das Bestimmen des maximalen Türklingelschaltungsstroms, der die Türklingelglocke nicht aktiviert, Folgendes umfasst:
(i) Bestimmen, ob der Strom, der durch die Türklingelschaltung entnommen wird, die Türklingelglocke aktiviert hat,
(ii) als Reaktion auf das Bestimmen, dass der Strom, der durch die Türklingelschaltung entnommen wird, die Türklingelglocke aktiviert hat, Verringern des durch die Türklingelschaltung entnommenen Stroms,
(iii) als Reaktion auf das Bestimmen, dass der Strom, der durch die Türklingelschaltung entnommen wird, die Türklingelglocke nicht aktiviert hat, Erhöhen des durch die Türklingelschaltung entnommenen Stroms; und
basierend auf dem Bestimmen des maximalen Türklingelschaltungsstroms, der die Türklingelglocke nicht aktiviert, Konfigurieren der Türklingelvorrichtung, um den bestimmten maximalen Türklingelschaltungsstrom durch die Türklingelschaltung zu entnehmen.

2. Türklingelvorrichtung nach Anspruch 1, wobei Bestimmen, ob der Strom, der durch die Türklingelschaltung entnommen wird, die Türklingelglocke aktiviert hat, das Erkennen einer Spannungsänderung über der Türklingelschaltung umfasst, wobei die Spannungsänderung über der Türklingelschaltung bei Aktivierung der Türklingelglocke auftritt.

3. Türklingelvorrichtung nach Anspruch 1, wobei das Aktivieren der Türklingelglocke umfasst, dass der durch die Türklingelschaltung entnommene Strom einen Elektromagneten in der Türklingelschaltung aktiviert, wobei der Elektromagnet von der Türklingelglocke in der Türklingelschaltung angezogen wird.

4. Türklingelvorrichtung nach Anspruch 1, wobei das Bestimmen, ob der Strom, der durch die Türklingelschaltung entnommen wird, die Türklingelglocke aktiviert hat, Folgendes umfasst:
Senden einer Anweisung an einen Benutzer über eine grafische Benutzeroberfläche (GUI) einer mobilen Vorrichtung, um auf einen Türklingelglockenton zu hören; und
Empfangen einer Rückmeldung von dem Benutzer über die GUI, wobei die Rückmeldung entweder umfasst, dass der Türklingelglockenton aktiviert wurde oder dass der Türklingelglockenton nicht aktiviert wurde.

5. Türklingelvorrichtung nach Anspruch 1, wobei das Bestimmen, ob der Strom, der durch die Türklingelschaltung entnommen wird, die Türklingelglocke aktiviert hat, das Erkennen einer Widerstandsänderung über der Türklingelschaltung umfasst, wobei die Widerstandsänderung über der Türklingelschaltung bei Aktivierung der Türklingelglocke auftritt.

6. Türklingelvorrichtung nach Anspruch 5, wobei das Erkennen der Widerstandsänderung über der Türklingelschaltung das Erkennen einer Temperaturänderung in einer Elektromagnetspule in der Türklingelschaltung umfasst.

7. Türklingelvorrichtung nach Anspruch 6, wobei das Erkennen der Temperaturänderung das Überwachen einer Temperatur der Elektromagnetspule mit einem externen Infrarotsensor umfasst.

8. Türklingelvorrichtung nach Anspruch 6, wobei die Türklingelschaltung ferner einen Temperatursensor umfasst und wobei das Erkennen der Temperaturänderung das Überwachen der Temperatur der Elektromagnetspule mit dem Temperatursensor umfasst.

9. Türklingelvorrichtung nach Anspruch 1, wobei die Türklingelvorrichtung ferner ein Mikrofon umfasst und wobei das Bestimmen, ob der Strom, der durch die Türklingelschaltung entnommen wird, die Türklingelglocke aktiviert hat, das Erkennen eines Türklingelglockentons mit dem Mikrofon umfasst.

10. Türklingelvorrichtung nach Anspruch 1, wobei das Bestimmen, ob der Strom, der durch die Türklingelschaltung entnommen wird, die Türklingelglocke aktiviert hat, Folgendes umfasst:
Trainieren eines Modells zum maschinellen Lernen basierend auf Türklingeldaten, die an einem zentralen Server gespeichert sind;
basierend auf dem trainierten Modell für maschinelles Lernen Bestimmen einer Art von Türklingel, die verwendet wird, und eines vorbestimmten Stroms, der der Art der verwendeten Türklingel zugeordnet ist; und
Bestimmen, dass die Türklingelglocke aktiviert worden ist, wenn der durch die Türklingelschaltung entnommene Strom größer als der vorbestimmte Strom ist, der der Art der verwendeten Türklingel zugeordnet ist.

11. Türklingelvorrichtung nach Anspruch 10, wobei die Türklingeldaten Klassifizierungen von Türklingelglocken basierend auf mindestens einem von einem Türklingelglockenton, einer Türklingelglockentaktung, einer geografischen Position der Türklingelglocke oder einem Alter der Türklingelglocke umfassen und wobei jede Klassifizierung mit dem vorbestimmten Strom in Verbindung steht, der der Art der verwendeten Türklingel zugeordnet ist.

12. Türklingelvorrichtung nach Anspruch 11, wobei der Türklingelglockenton und die Türklingelglockentaktung der Türklingelvorrichtung durch eine Vielzahl von Internet-of-Things-(IoT-) Vorrichtungen erfasst werden.

13. Türklingelvorrichtung nach Anspruch 1, wobei der durch die Türklingelschaltung entnommene Strom basierend auf einem Tastverhältnis entnommen wird, und wobei der maximale Strom ein Maximum im Zeitverlauf umfasst.

14. Verfahren zum Konfigurieren einer Türklingelvorrichtung, umfassend:
Entnehmen eines Stroms durch eine Türklingelschaltung;
während des Entnehmens des Stroms durch die Türklingelschaltung, Bestimmen, durch die Türklingelvorrichtung eines maximalen Türklingelschaltungsstroms, der die Türklingelglocke nicht aktiviert, wobei das Bestimmen des maximalen Türklingelschaltungsstroms, der die Türklingelglocke nicht aktiviert, Folgendes umfasst:
(i) Bestimmen, ob der Strom, der durch die Türklingelschaltung entnommen wird, die Türklingelglocke aktiviert hat,
(ii) wenn der Strom, der durch die Türklingelschaltung entnommen wird, die Türklingelglocke aktiviert hat, Verringern des durch die Türklingelschaltung entnommenen Stroms,
(iii) wenn der Strom, der durch die Türklingelschaltung entnommen wird, die Türklingelglocke nicht aktiviert hat, Erhöhen des durch die Türklingelschaltung entnommenen Stroms; und
basierend auf dem Bestimmen des maximalen Türklingelschaltungsstroms, der die Türklingelglocke nicht aktiviert, Konfigurieren der Türklingelvorrichtung, um den bestimmten maximalen Türklingelschaltungsstrom durch die Türklingelschaltung zu entnehmen.

15. Nichtflüchtiges computerlesbares Medium mit darauf gespeicherten computerausführbaren Anweisungen, die durch mindestens einen Prozessor ausführbar sind, um zu bewirken, dass ein Rechensystem Operationen durchführt, umfassend:
Entnehmen eines Stroms durch eine Türklingelschaltung;
während des Entnehmens des Stroms durch die Türklingelschaltung, Bestimmen eines maximalen Türklingelschaltungsstroms, der eine Türklingelglocke nicht aktiviert, wobei das Bestimmen des maximalen Türklingelschaltungsstroms, der die Türklingelglocke nicht aktiviert, Folgendes umfasst:
(i) Bestimmen, ob der Strom, der durch die Türklingelschaltung entnommen wird, die Türklingelglocke aktiviert hat,
(ii) als Reaktion auf das Bestimmen, dass der Strom, der durch die Türklingelschaltung entnommen wird, die Türklingelglocke aktiviert hat, Verringern des durch die Türklingelschaltung entnommenen Stroms,
(iii) als Reaktion auf das Bestimmen, dass der Strom, der durch die Türklingelschaltung entnommen wird, die Türklingelglocke nicht aktiviert hat, Erhöhen des durch die Türklingelschaltung entnommenen Stroms; und
basierend auf dem Bestimmen des maximalen Türklingelschaltungsstroms, der die Türklingelglocke nicht aktiviert, Konfigurieren einer Türklingelvorrichtung, um den bestimmten maximalen Türklingelschaltungsstrom durch die Türklingelschaltung zu entnehmen.

## Revendications

1. Dispositif de sonnette de porte (102) comprenant :
un bouton de sonnette de porte (104) ;
un dispositif de stockage d'énergie (106) configuré pour fournir de l'énergie afin de faire fonctionner le dispositif de sonnette de porte ;
des connecteurs électriques (108) configurés pour connecter électriquement le dispositif de sonnette de porte dans un circuit de sonnette de porte (100) avec un carillon de sonnette de porte (150) et un transformateur (190), dans lequel le transformateur fournit du courant au circuit de sonnette de porte ;
un contrôleur (110) comprenant au moins un processeur (112) et un dispositif de stockage de données non transitoire (114), dans lequel le dispositif de stockage de données non transitoire stocke des instructions de programme (116) exécutables par le processeur pour amener le dispositif de sonnette de porte à effectuer des opérations comprenant :
le tirage d'un courant à travers le circuit de sonnette de porte ;
pendant le tirage du courant à travers le circuit de sonnette de porte, la détermination d'un courant de circuit de sonnette de porte maximum qui n'activera pas le carillon de sonnette de porte, dans lequel la détermination du courant de circuit de sonnette de porte maximum qui n'activera pas le carillon de sonnette de porte comprend :
(i) la détermination si le courant étant tiré à travers le circuit de sonnette de porte a activé le carillon de sonnette de porte,
(ii) en réponse à la détermination que le courant étant tiré à travers le circuit de sonnette de porte a activé le carillon de sonnette de porte, la décrémentation du courant tiré à travers le circuit de sonnette de porte,
(iii) en réponse à la détermination que le courant étant tiré à travers le circuit de sonnette de porte n'a pas activé le carillon de sonnette de porte, l'incrémentation du courant tiré à travers le circuit de sonnette de porte ; et
sur la base de la détermination du courant de circuit de sonnette de porte maximum qui n'activera pas le carillon de sonnette de porte, la configuration du dispositif de sonnette de porte pour tirer le courant de circuit de sonnette de porte maximum déterminé à travers le circuit de sonnette de porte.

2. Dispositif de sonnette de porte selon la revendication 1, dans lequel la détermination si le courant étant tiré à travers le circuit de sonnette de porte a activé le carillon de sonnette de porte comprend la détection d'un changement de tension à travers le circuit de sonnette de porte, dans lequel le changement de tension à travers le circuit de sonnette de porte se produit lors de l'activation du carillon de sonnette de porte.

3. Dispositif de sonnette de porte selon la revendication 1, dans lequel l'activation du carillon de sonnette de porte comprend l'activation par le courant tiré à travers le circuit de sonnette de porte d'un électroaimant dans le circuit de sonnette de porte, dans lequel l'électroaimant est attiré vers le carillon de sonnette de porte dans le circuit de sonnette de porte.

4. Dispositif de sonnette de porte selon la revendication 1, dans lequel la détermination si le courant étant tiré à travers le circuit de sonnette de porte a activé le carillon de sonnette de porte comprend :
l'envoi d'une instruction à un utilisateur, via une interface utilisateur graphique (GUI) d'un dispositif mobile, pour écouter un son de carillon de sonnette de porte ; et
la réception d'un retour de part de l'utilisateur via l'interface graphique, dans lequel le retour indique soit que le son de carillon de sonnette de porte a été activé, soit que le son de carillon de sonnette de porte n'a pas été activé.

5. Dispositif de sonnette de porte selon la revendication 1, dans lequel la détermination si le courant étant tiré à travers le circuit de sonnette de porte a activé le carillon de sonnette de porte comprend la détection d'un changement de résistance à travers le circuit de sonnette de porte, dans lequel le changement de résistance à travers le circuit de sonnette de porte se produit lors de l'activation du carillon de sonnette de porte.

6. Dispositif de sonnette de porte selon la revendication 5, dans lequel la détection du changement de résistance à travers le circuit de sonnette de porte comprend la détection d'un changement de température dans une bobine d'électroaimant dans le circuit de sonnette de porte.

7. Dispositif de sonnette de porte selon la revendication 6, dans lequel la détection du changement de température comprend la surveillance d'une température de la bobine d'électroaimant avec un capteur infrarouge externe.

8. Dispositif de sonnette de porte selon la revendication 6, dans lequel le circuit de sonnette de porte comprend en outre un capteur de température, et dans lequel la détection du changement de température comprend la surveillance de la température de la bobine d'électroaimant avec le capteur de température.

9. Dispositif de sonnette de porte selon la revendication 1, dans lequel le dispositif de sonnette de porte comprend en outre un microphone, et dans lequel la détermination si le courant étant tiré à travers le circuit de sonnette de porte a activé le carillon de sonnette de porte comprend la détection, avec le microphone, d'un son de carillon de sonnette de porte.

10. Dispositif de sonnette de porte selon la revendication 1, dans lequel la détermination si le courant étant tiré à travers le circuit de sonnette de porte a activé le carillon de sonnette de porte comprend :
l'entraînement d'un modèle d'apprentissage automatique sur la base des données de sonnette de porte stockées sur un serveur central ;
la détermination, sur la base du modèle d'apprentissage automatique entraîné, d'un type de sonnette de porte étant utilisé et d'un courant prédéterminé associé au type de sonnette de porte étant utilisé ; et
la détermination que le carillon de sonnette de porte a été activé lorsque le courant tiré à travers le circuit de sonnette de porte est supérieur au courant prédéterminé associé au type de sonnette de porte étant utilisé.

11. Dispositif de sonnette de porte selon la revendication 10, dans lequel les données de sonnette de porte comprennent des classifications de carillons de sonnette de porte sur la base d'au moins l'un d'un son de carillon de sonnette de porte, d'une synchronisation de carillon de sonnette de porte, d'un emplacement géographique du carillon de sonnette de porte, ou d'un âge du carillon de sonnette de porte, et dans lequel chaque classification est liée au courant prédéterminé associé au type de sonnette de porte étant utilisé.

12. Dispositif de sonnette de porte selon la revendication 11, dans lequel le son de carillon de sonnette de porte et la synchronisation de carillon de sonnette de porte du dispositif de sonnette de porte sont détectés par une pluralité de dispositifs Internet des objets (IoT).

13. Dispositif de sonnette de porte selon la revendication 1, dans lequel le courant tiré à travers le circuit de sonnette de porte est tiré sur la base d'un cycle de service, et dans lequel le courant maximum comprend un maximum au fil du temps.

14. Procédé de configuration d'un dispositif de sonnette de porte comprenant :
le tirage d'un courant à travers un circuit de sonnette de porte ;
pendant le tirage du courant à travers le circuit de sonnette de porte, la détermination, par le dispositif de sonnette de porte, d'un courant de circuit de sonnette de porte maximum qui n'activera pas le carillon de sonnette de porte, dans lequel la détermination du courant de circuit de sonnette de porte maximum qui n'activera pas le carillon de sonnette de porte comprend :
(i) la détermination si le courant étant tiré à travers le circuit de sonnette de porte a activé le carillon de sonnette de porte,
(ii) si le courant étant tiré à travers le circuit de sonnette de porte a activé le carillon de sonnette de porte, la décrémentation du courant tiré à travers le circuit de sonnette de porte,
(iii) si le courant étant tiré à travers le circuit de sonnette de porte n'a pas activé le carillon de sonnette de porte, l'incrémentation du courant tiré à travers le circuit de sonnette de porte ; et
sur la base de la détermination du courant de circuit de sonnette de porte maximum qui n'activera pas le carillon de sonnette de porte, la configuration du dispositif de sonnette de porte pour tirer le courant de circuit de sonnette de porte maximum déterminé à travers le circuit de sonnette de porte.

15. Support non transitoire lisible par ordinateur sur lequel sont stockées des instructions exécutables par ordinateur exécutables par au moins un processeur pour amener un système informatique à réaliser des opérations, comprenant :
le tirage d'un courant à travers un circuit de sonnette de porte ;
pendant le tirage du courant à travers le circuit de sonnette de porte, la détermination d'un courant de circuit de sonnette de porte maximum qui n'activera pas un carillon de sonnette de porte, dans lequel la détermination du courant de circuit de sonnette de porte maximum qui n'activera pas le carillon de sonnette de porte comprend :
(i) la détermination si le courant étant tiré à travers le circuit de sonnette de porte a activé le carillon de sonnette de porte,
(ii) en réponse à la détermination que le courant étant tiré à travers le circuit de sonnette de porte a activé le carillon de sonnette de porte, la décrémentation du courant tiré à travers le circuit de sonnette de porte,
(iii) en réponse à la détermination que le courant étant tiré à travers le circuit de sonnette de porte n'a pas activé le carillon de sonnette de porte, l'incrémentation du courant tiré à travers le circuit de sonnette de porte ; et
sur la base de la détermination du courant de circuit de sonnette de porte maximum qui n'activera pas le carillon de sonnette de porte, la configuration d'un dispositif de sonnette de porte pour tirer le courant de circuit de sonnette de porte maximum déterminé à travers le circuit de sonnette de porte.
